# EUROPEAN PATENT SPECIFICATION

(11) **EP 2 593 970 B1**
(45) Date of publication and mention of the grant of the patent: **24.05.2017**
(21) Application number: 11743367.2
(22) Date of filing: 05.07.2011
(51) Int. Cl.: H01L 31/055, H01L 31/0232, C03C 3/15, C03C 4/12

(54) **CONVERTER MATERIAL FOR LUMINESCENT SOLAR CONCENTRATORS**
UMRICHTERMATERIAL FÜR LUMINESZIERENDE SOLARKONZENTRATOREN
MATÉRIAU DE CONVERSION POUR CONCENTRATEUERS SOLAIRES LUMINESCENTS

(30) Priority: 13.07.2010 EP 10169389
(43) Date of publication of application: 22.05.2013
(73) Proprietor: Philips Lighting Holding B.V., 5656 AE Eindhoven (NL)
(72) Inventor: RONDA, Cornelis, R., NL-5656 AE Eindhoven (NL); DE BOER, Dirk, K. G., NL-5656 AE Eindhoven (NL); MEIJERINK, Andries, NL-5656 AE Eindhoven (NL); CHRISTOGIANNIS, Nikolaos, NL-5656 AE Eindhoven (NL); BEELEN, Daniela, NL-5656 AE Eindhoven (NL); KEUR, Wilco, NL-5656 AE Eindhoven (NL)
(74) Representative: van Eeuwijk, Alexander Henricus Waltherus
(86) International application number: PCT/IB2011/052972
(87) International publication number: WO 2012/007872

(56) References cited:
- DE-A1-102006 062 448
- JP-A- 2003 142 716
- US-A1- 2010 139 749
- KAWANO K ET AL: "Improvement of the conversion efficiency of solar cell by rare earth ion", OPTICAL MATERIALS, ELSEVIER SCIENCE PUBLISHERS B.V. AMSTERDAM, NL, vol. 31, no. 9, 1 July 2009 (2009-07-01), pages 1353-1356, XP026184632, ISSN: 0925-3467, DOI: 10.1016/J.OPTMAT.2008.10.012 [retrieved on 2008-11-20]
- SEONGTAE PARK ET AL: "X-ray-induced reduction of Sm3+-doped SrB6O10 and its room temperature optical hole burning; X-ray-induced reduction of Sm3+-doped SrB 1/2 6O 1/2 10 and its room temperature optical hole burning", JOURNAL OF PHYSICS: CONDENSED MATTER, INSTITUTE OF PHYSICS PUBLISHING, BRISTOL, GB, vol. 18, no. 4, 1 February 2006 (2006-02-01), pages 1267-1274, XP020102805, ISSN: 0953-8984, DOI: 10.1088/0953-8984/18/4/012
- SAHNOUN M ET AL: "Full potential calculation of structural, electronic and optical properties of KMgF3", MATERIALS CHEMISTRY AND PHYSICS, ELSEVIER SA, SWITZERLAND, TAIWAN, REPUBLIC OF CHINA, vol. 91, no. 1, 15 May 2005 (2005-05-15), pages 185-191, XP027858521, ISSN: 0254-0584 [retrieved on 2005-05-15]
- VERWEY J W M ET AL: "The luminescence of divalent and trivalent rare earth ions in the crystalline and glass modifications of SrB4O7", JOURNAL OF PHYSICS AND CHEMISTRY OF SOLIDS, PERGAMON PRESS, LONDON, GB, vol. 53, no. 3, 1 March 1992 (1992-03-01), pages 367-375, XP024580948, ISSN: 0022-3697, DOI: 10.1016/0022-3697(92)90170-I [retrieved on 1992-03-01]

## Description

### FIELD OF THE INVENTION

The present invention is directed to solar cells comprising materials for solar cells

### BACKGROUND OF THE INVENTION

State of the art solar cells cannot achieve the theoretical efficiency (as determined by the so-called "Shockley-Queisser" limit) for various reasons. Therefore many attempts have been made to increase the efficiency of Solar cells by either varying the solar cell material or addition of further components etc. Alternatively, the cost of solar cells can be reduced by the use of solar energy concentrators. Both measures have the potential to increase the use of solar cells as the costs per Wp decrease.

One strategy for the increase of solar cells is the introduction of converter materials which (most desirably) have a broadband absorption and line emission in desired wavelength areas. However there are not many converter materials known and therefore there is the constant need for alternative converter materials. These materials are used in so-called luminescent solar energy concentrators (LSC). Sunlight impinges on a large area, is converted into light of longer wavelenght and subsequently guided to photovoltaic elements. In this way the amount of expensive photovoltaic material to be used can be reduced considerably. Luminescent solar energy concentrators are known from US201/0139749 A1.

### SUMMARY OF THE INVENTION

It is an object of the present invention to provide a luminescent solar energy concentrator comprising a converter material for solar cells which is able to decrease the costs and to increase efficiency for the conversion of deep blue/UV radiation of solar cells by a broadband absorption and line emission in suitable wavelength areas.

This object is solved by a solar cell according to claim 1 of the present invention.

A Sm²⁺ inorganic material is known from "The luminescence of divalent and trivalent rare earth ions in the crystalline and glass modifications of SrB₄O₇, Verwey et al., J. Phys. Chem. Solidis, Vol. 53, No. 3, pp. 367-375, 1992".

A Sm²⁺ inorganic material has for a wide range of applications at least one of the following advantages:
- The materials comprising Sm²⁺ employ for many applications a large Stokes shift,
- The efficiency is increased as the conversion efficiency of solar cells is decreasing rapidly below 400 nm.
- The costs of solar cells are decreased when those materials are used in solar cells, such as LSCs.
- Furthermore many of those materials show a broad tunable absorption spectrum
- In most of those materials line emission can be observed which prevents reabsorption (forbidden transitions)
- Furthermore it has been found that said line emission is (almost) independent of the host lattice, enabling the use of more than one luminescent material (to absorb as much sunlight as possible) in combination with interference filters, to keep the emission within the solar cellThe converter material used in the solar cell of the present invention is an Sm²⁺ doped earth-alkaline borate.

According to the present invention, the converter material has a band gap of ≥4.5 eV. This has been advantageous for many applications since then it has been found that in materials with too small a value for the bandgap, the excited Sm²⁺ ions easily oxidise to Sm³⁺ and this results in quenching of the emission. Preferably the converter material has a band gap of ≥5 eV.

According to a preferred embodiment, the undoped material is a non-coloured material which is coloured when doped with Sm²⁺.

The term "non-coloured" especially means and/or includes that the material has no absorption in the visible wavelength area or an absorption of ≤ 10%, whereas the term "coloured" to the contrary especially means and/or includes that the material has an absorption and/or emission (preferably of larger than 50%) in the visible wavelength area.

According to the invention, the converter material comprises an earth-alkaline borate, preferably a material of the structure EA₁₋ₓB₄O₇:Smₓ with EA being an earth alkaline metal or mixtures of earth alkaline metals. Preferably EA is Sr and/or Ba.

This material has shown in practice to be a very good converter material as will be described later on. The converter material is provided in the inventive solar cell in nanoparticle form, preferably with an average particle size of ≥1 nm and ≤ 1 µm, preferably ≥100nm and ≤ 500nm, most preferred ≥50 nm and ≤ 100nm. According to the invention the converter is present in a light guide, and scattering losses are reduced in this way, since, according to the invention, the difference in the refractive indices (Δn) of the light guide and the phosphor materials is < 0.05. According to an example not forming part of the invention, the converter material is provided in said solar cells in form of grains with with an average particle size of ≥ 1 µm, more preferred ≥ 5 µm. This arrangement is especially advantageous when the converting layer is positioned under the light guide with respect to the direction of the light.

### BRIEF DESCRIPTION OF THE DRAWINGS

Additional details, features, characteristics and advantages of the object of the invention are disclosed in the subclaims, the figures and the following description of the respective figures and examples, which -- in an exemplary fashion-- show several embodiments and examples of converter material for solar cells according to the invention.
Fig. 1 shows an emission spectrum of a material used in the inventive solar cell according to the present invention (Example I)
Fig. 2 shows the excitation spectrum of the material of Fig. 1 The invention will furthermore be understood by the following Inventive Example which is merely for illustration of the invention only and non- limiting.

### EXAMPLE I

Example I refers to SrB₄O₇:Sm²⁺ which was made the following way:
Stoichiometrically mixtures of Sm₂O₃, SrCO₃, H₃BO₃ (10% excess) were fired at 850 °C for 20 hours in a reducing atmosphere (H₂/N₂). The samples were checked by x-ray diffraction technique and their phase purity was confirmed.

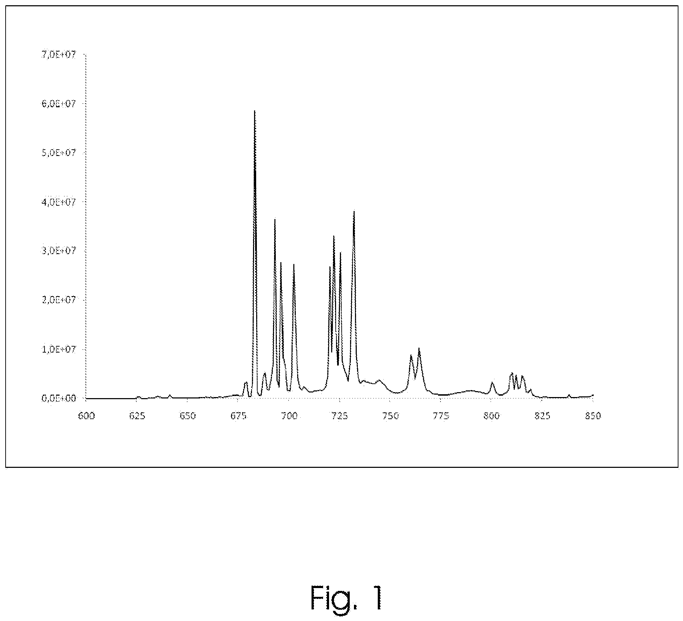

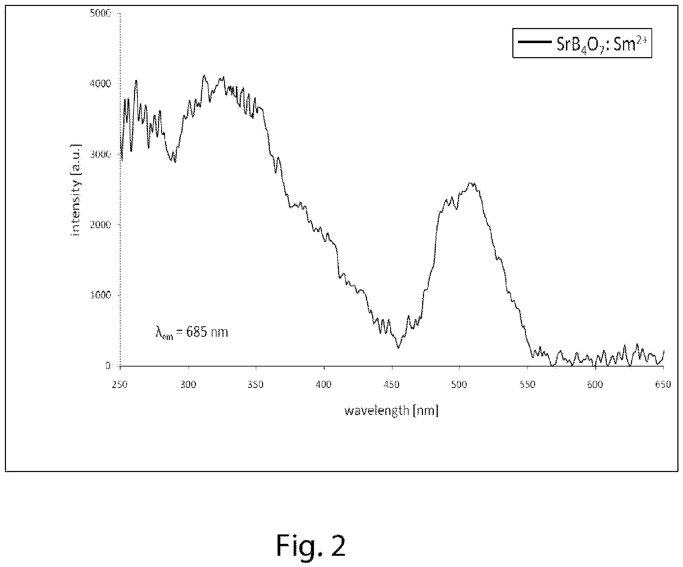

Fig. 1 shows the emission spectrum, Fig. 2 shows the excitation spectrum of SrB₄O₇:Sm²⁺. It can clearly be seen that this material is an excellent material of use in converter material for solar cells due to the broadband absorption of the material as well as the line emission together with a broad Stokes shift. The invention's scope is defined in the following claims. Furthermore, reference signs used in the description and claims do not limit the scope of the invention as claimed.

## Claims

1. A solar cell comprising a converter material for solar cells wherein said converter material for solar cells comprises a Sm²⁺ doped inorganic material, whereby the converter material has a band gap of ≥ 4.5 eV, the converter material comprises an earth-alkaline borate and the converter material is provided in the form of nanoparticles and the converter material is present in a light guide and the solar cell is a luminescent solar energy concentrator, wherein the difference in the refractive indices (Δn) of the light guide and the converter material is < 0.05.

2. The solar cell of claim 1, whereby the converter material is provided in said solar cell with an average particle size of ≥1 nm and ≤1 µm.

3. The solar cell of claim 1, whereby the earth-alkaline borate is a material of the structure SrB₄O₇:Sm²⁺.

4. The solar cell of any of the claims 1 to 3 whereby the emission of the converter material has a decay time of ≥50 µs.

5. The solar cell of any of the claims 1 to 4, whereby the inorganic material in the undoped form is a non-colored material which is colored when doped with Sm²⁺.

## Patentansprüche

1. Solarzelle, Umrichtermaterial für Solarzellen umfassend, wobei das besagte Umrichtermaterial für Solarzellen ein mit Sm²⁺ dotiertes anorganisches Material umfasst, wobei das Umrichtermaterial eine Bandlücke von ≥ 4,5 eV aufweist, das Umrichtermaterial ein erdalkalisches Borat umfasst und das Umrichtermaterial in Form von Nanopartikeln vorhanden ist, und das Umrichtermaterial in einem Lichtleiter präsent ist und die Solarzelle ein lumineszierender Solarkonzentrator ist, wobei der Unterschied der Brechungsindizes (Δn) des Lichtleiters und des Umrichtermaterials < 0,05 ist.

2. Solarzelle nach Anspruch 1, wobei das Umrichtermaterial in der besagten Solarzelle mit einer durchschnittlichen Partikelgröße von ≥ 1 nm und ≤ 1 µm vorhanden ist.

3. Solarzelle nach Anspruch 1, wobei das erdalkalische Borat ein Material mit der Struktur SrB₄O₇:Sm²⁺ ist.

4. Solarzelle nach irgendeinem der Ansprüche 1 bis 3, wobei die Abgabe des Umrichtermaterials eine Abklingzeit von ≥ 50 µs aufweist.

5. Solarzelle nach irgendeinem der Ansprüche 1 bis 4, wobei das anorganische Material in der undotierten Form ein farbloses Material ist, das gefärbt wird, wenn es mit Sm²⁺ dotiert ist.

## Revendications

1. Cellule solaire comprenant un matériau convertisseur pour des cellules solaires, dans laquelle ledit matériau convertisseur pour des cellules solaires comprend un matériau inorganique dopé au Sm²⁺, dans laquelle le matériau convertisseur a une bande interdite ≥ 4,5 eV, le matériau convertisseur comprend un borate alcalinoterreux et le matériau convertisseur est prévu sous la forme de nanoparticules et le matériau convertisseur est présent dans un guide de lumière et la cellule solaire est un concentrateur d'énergie solaire luminescent, dans laquelle la différence des indices de réfraction (Δn) du guide de lumière et du matériau convertisseur est < 0,05.

2. Cellule solaire selon la revendication 1, dans laquelle le matériau convertisseur est prévu dans ladite cellule solaire avec une taille de particule moyenne de ≥ 1 nm et ≤ 1 µm.

3. Cellule solaire selon la revendication 1, dans laquelle le borate alcalinoterreux est un matériau de la structure SrB₄O₇:Sm²⁺.

4. Cellule solaire selon l'une quelconque des revendications 1 à 3, dans laquelle l'émission du matériau convertisseur a un temps de déclin de ≥ 50 µs.

5. Cellule solaire selon l'une quelconque des revendications 1 à 4, dans laquelle le matériau inorganique sous la forme non dopée est un matériau non coloré qui est coloré lorsqu'il est dopé au Sm²⁺.
